# FASCICULE DE BREVET EUROPEEN

(11) **EP 3 081 061 B1**
(45) Date de publication et mention de la délivrance du brevet: **15.01.2020**
(21) Numéro de dépôt: 14803155.2
(22) Date de dépôt: 28.11.2014
(51) Int. Cl.: H05K 7/14, G06F 1/18

(54) **BOÎTIER POUR AU MOINS UNE CARTE ÉLECTRONIQUE**
GEHÄUSE FÜR MINDESTENS EINE ELEKTRONISCHE KARTE
HOUSING FOR AT LEAST ONE ELECTRONIC CARD

(30) Priorité: 11.12.2013 FR 1362402
(43) Date de publication de la demande: 19.10.2016
(73) Titulaire: Enensys Technologies, 35510 Cesson Sévigné (FR)
(72) Inventeur: DENIAU, Eric, F-35510 Cesson Sevigne (FR); ROUL, Laurent, F-35510 Cesson Sevigne (FR); SISOMSACK, Jacques, F-35510 Cesson Sevigne (FR)
(74) Mandataire: Cabinet Le Guen Maillet
(86) Numéro de dépôt international: PCT/EP2014/075911
(87) Numéro de publication internationale: WO 2015/086340

(56) Documents cités:
- WO-A2-2010/138824
- US-A1- 2010 124 473
- US-A1- 2012 243 178
- US-B1- 7 099 160

## Description

La présente invention concerne un boîtier pour au moins une carte électronique.

Un boîtier pour cartes électroniques, destiné par exemple à être monté dans une armoire-rack d'un serveur informatique, comporte un châssis généralement en métal à l'intérieur duquel sont fixés de nombreux composants : cartes électroniques, alimentations électriques, rails de guidage, ...

Les composants sont généralement fixés par des vis de serrage. Un tel assemblage s'avère être long et fastidieux et nécessite l'emploi de nombreux composants mécaniques (vis, boulons, inserts) pour assurer le bon maintien des composants.

Le document US-B-7,099,160 divulgue un boîtier pour au moins une carte électronique présentant un connecteur.

L'objet de la présente invention est de proposer un boîtier pour au moins une carte électronique qui ne présente pas les inconvénients de l'art antérieur et qui en particulier permet une mise en place et une fixation solide, rapide et aisée des cartes électroniques dans le châssis sans vis de fixation.

A cet effet, est proposé un boîtier pour au moins une carte électronique présentant un connecteur, ledit boîtier comportant :
- un châssis présentant:
   - un fond présentant au moins un élément femelle et au moins un logement,
   - un capot, et
   - une paroi d'insertion présentant pour la ou chaque carte électronique, une fenêtre par où ladite carte électronique peut être introduite ou extraite du châssis selon une direction de translation,
- pour la ou chaque carte électronique, deux parois de guidage, chacune comportant, pour la ou chaque carte électronique, une rainure de guidage orientée parallèlement à la direction de translation et destinée à recevoir ladite carte électronique,
chaque paroi de guidage comportant:
- au moins un élément mâle prévu pour coopérer avec un élément femelle par insertion dudit élément mâle dans ledit élément femelle,
- une languette disposée à l'extrémité de la paroi de guidage orientée du côté opposé à la paroi d'insertion, prenant la forme d'un bras présentant, à son extrémité libre, un plot prévu pour s'insérer dans un logement,
- un clip disposé à l'extrémité de la paroi de guidage orientée du côté opposé à la paroi d'insertion et prenant la forme d'une lamelle élastique munie à son extrémité libre d'une dent orientée vers le fond, et la face de la lamelle qui est orientée vers le capot étant prévue pour venir en appui contre ce-dernier, et
- une carte électronique fond de panier s'étendant parallèlement au plan de la paroi d'insertion, présentant un connecteur récepteur prévu pour s'accoupler avec ledit connecteur, et prévue pour s'insérer entre la lamelle et le bras.

Avantageusement, chaque élément femelle prend la forme d'un embouti du fond vers l'intérieur du châssis avec une ouverture orientée du côté opposé à la paroi d'insertion, et chaque élément mâle prend la forme d'une barrette issue de la paroi de guidage, disposée sous celle-ci et orientée vers la paroi d'insertion.

Avantageusement, la carte électronique fond de panier présente, le long d'au moins l'un de ses deux bords parallèles au fond, au moins une échancrure prévue pour y loger une lamelle ou un bras.

Avantageusement, la paroi d'insertion présente un pli s'étendant parallèlement au-dessus du fond et présentant, pour chaque paroi de guidage, un embouti vers l'intérieur du châssis présentant une rainure parallèle à la direction de translation et débouchant au niveau de l'extrémité libre du pli et dans laquelle coulisse une extension de ladite paroi de guidage qui présente pour chaque bord de la rainure de l'embouti, une rainure dans laquelle loge ladite rainure de l'embouti.

Avantageusement, la carte électronique est associée à un ou deux systèmes de maintien et d'extraction, chacun comportant une empreinte femelle réalisée sur le côté de la paroi de guidage, et un levier monté mobile en rotation sur la carte électronique autour d'un axe de rotation perpendiculaire au plan de la carte électronique et dont une poignée dépasse vers l'extérieur, le levier présente une dent orientée vers l'extérieur et destinée à s'insérer dans l'empreinte femelle sous l'effet d'un moyen formant ressort.

Avantageusement, le moyen formant ressort prend la forme d'une languette disposée en aval de la dent en face de l'extrémité de la paroi de guidage.

Avantageusement, le levier comporte une paroi formant butée contre laquelle ladite languette vient en butée lors de l'extraction de la carte électronique.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 est une vue en perspective d'un boîtier selon l'invention pour au moins une carte électronique,
la Fig. 2 est une coupe selon le plan II de la Fig. 1,
la Fig. 3 est une coupe selon la ligne III-III de la Fig. 2,
la Fig. 4 est une coupe selon le plan IV de la Fig. 1,
la Fig. 5 est une vue de dessus d'un détail du boîtier selon l'invention, et
la Fig. 6 est une coupe selon la droite VI-VI de la Fig. 5.

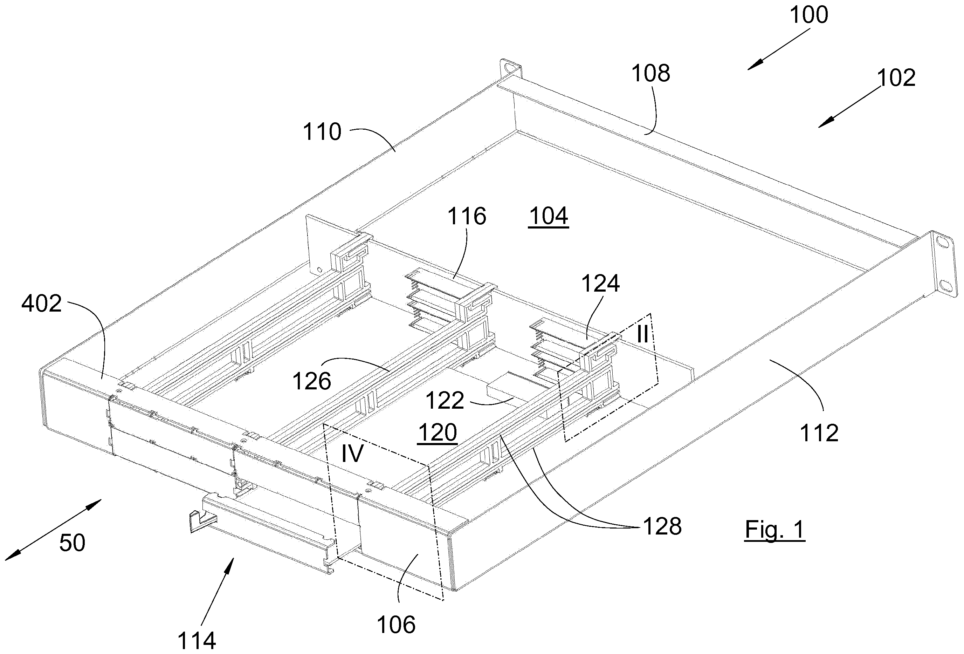

La Fig. 1 montre un boîtier 100 pour au moins une carte électronique 120. Dans le mode de réalisation de l'invention présenté sur la Fig. 1, il y a une carte électronique 120, mais il est prévu de pouvoir en placer plus d'une.

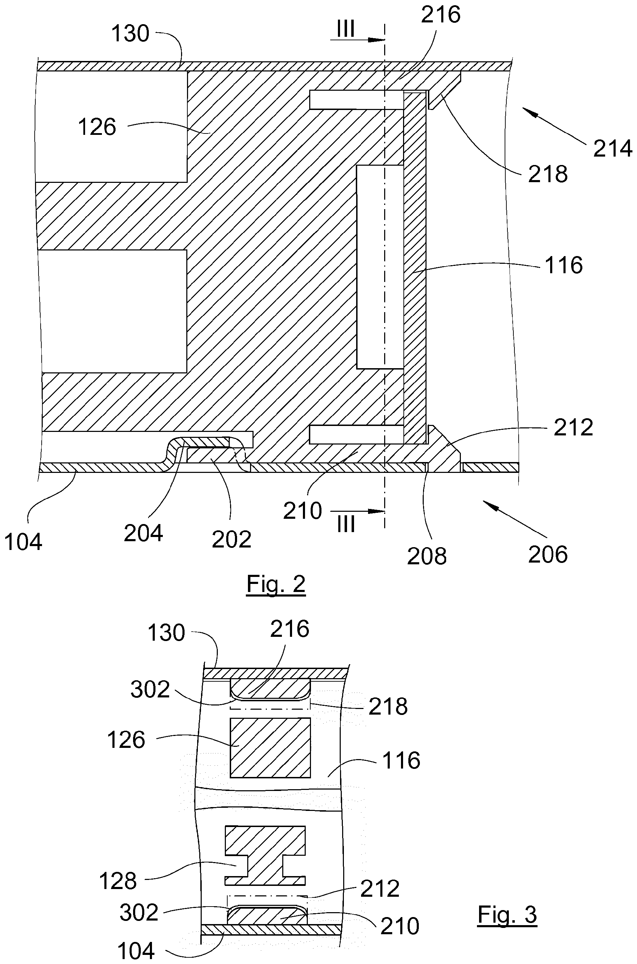

Le boîtier 100 comporte un châssis 102 qui présente un fond 104, une paroi d'insertion 106 qui est ici la paroi arrière et un capot 130 (Figs. 2 et 3).

Dans le mode de réalisation de l'invention présenté sur la Fig. 1, le châssis 102 comporte également une paroi frontale 108 et deux parois latérales 110 et 112.

Le châssis 102 forme ainsi une cuve fermée à l'intérieur de laquelle sont logées les cartes électroniques 120.

Pour chaque carte électronique 120, la paroi d'insertion 106 présente une fenêtre 114 par où ladite carte électronique 120 est introduite ou extraite du châssis 102 selon une direction de translation 50 perpendiculaire au plan de la paroi d'insertion 106.

Chaque carte électronique 120 présente un connecteur 122 qui est fixé le long du bord de ladite carte électronique 120 qui est introduite la première par la fenêtre 114, c'est-à-dire ici le bord qui est orienté du côté opposé à la paroi d'insertion 106.

Lors de l'introduction de la carte électronique 120, le connecteur 122 s'accouple avec un connecteur récepteur 124 qui est fixé sur une carte électronique fond de panier 116 qui s'étend parallèlement au plan de la paroi d'insertion 106 et perpendiculairement au fond 104 et qui est maintenu dans le châssis 102.

Le boîtier 100 comporte également des parois de guidage 126 qui sont fixées dans le châssis 102 et plus particulièrement au fond 104. Chaque paroi de guidage 126 s'étend de la paroi d'insertion 106 à la carte électronique fond de panier 116 dans un plan perpendiculaire au fond 104 et perpendiculaire au plan de paroi d'insertion 106, c'est-à-dire parallèlement à la direction de translation 50.

Chaque carte électronique 120 est disposée entre deux parois de guidage 126 qui comportent chacune, pour ladite carte électronique 120, une rainure de guidage 128. Chaque rainure de guidage 128 s'étend parallèlement au fond 104 et donc parallèlement à la direction de translation 50 et est destinée à recevoir un des deux bords de la carte électronique 120 qui est orienté parallèlement à la direction de translation 50.

Ainsi, lors de l'introduction ou de l'extraction de la carte électronique 120 du châssis 102, ladite carte électronique 120 est guidée par les deux rainures de guidage 128 des parois de guidage 126 voisines dans lesquelles ses deux bords sont insérés.

Dans le mode de réalisation de l'invention présenté sur la Fig. 1, il y a trois parois de guidage 126, chacune présentant, de part et d'autre de la paroi de guidage 126, deux rainures de guidage 128 superposées. Ainsi, pour chaque paire de parois de guidage 126, il est possible de guider deux cartes électroniques 120 superposées.

Bien sûr, il est possible de mettre en place plus de deux rainures de guidage 128 par paroi de guidage 126, et donc plus généralement au moins une.

Chaque paroi de guidage 126 est réalisée en un matériau rigide et électriquement isolant comme par exemple en nylon.

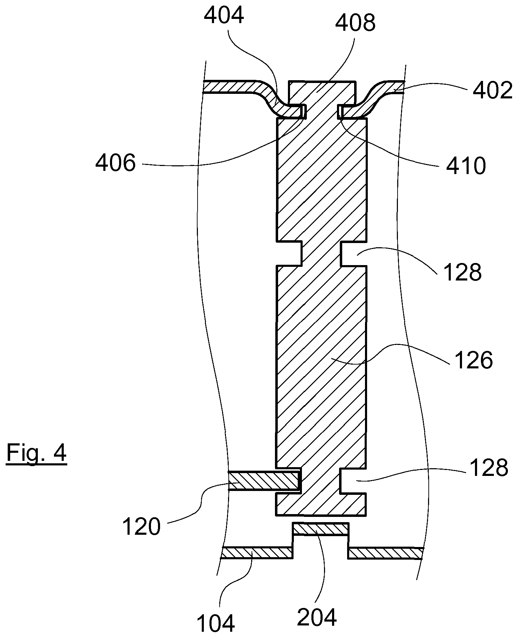

La Fig. 2 montre une coupe de la paroi de guidage 126 au voisinage de la carte électronique fond de panier 116 et la Fig. 4 montre la paroi de guidage 126 au voisinage de la paroi d'insertion 106.

Pour fixer la paroi de guidage 126, celle-ci comporte, répartis sur sa longueur, au moins un élément mâle 202 et le fond 104 présente au moins un élément femelle 204. Chaque élément femelle 204 est prévu pour coopérer avec un élément mâle 202 par insertion dudit élément mâle 202 dans ledit élément femelle 204 pour assurer la fixation de la paroi de guidage 126 sur le fond 104.

Chaque élément femelle 204 prend la forme d'un embouti du fond 104 vers l'intérieur du châssis 102 avec une ouverture orientée du côté opposé à la paroi d'insertion 106, c'est-à-dire ici vers la paroi frontale 108.

Chaque élément mâle 202 prend la forme d'une barrette issue de la paroi de guidage 126, disposée sous celle-ci et orientée vers la paroi d'insertion 106.

Ainsi, en faisant glisser la paroi de guidage 126 depuis l'intérieur du châssis 102, vers la paroi d'insertion 106, chaque élément mâle 202 se loge dans un élément femelle 204 en traversant son ouverture.

Pour assurer le blocage en translation de la paroi de guidage 126 après sa mise en place, celle-ci comporte une languette 206 disposée à l'extrémité de la paroi de guidage 126 qui est orientée du côté opposé à la paroi d'insertion 106, c'est-à-dire ici vers la paroi frontale 108, et le fond 104 présente un logement 208. La languette 206 est prévue pour s'insérer dans le logement 208 et ainsi bloquer la paroi de guidage 126.

La languette 206 prend ici la forme d'un bras 210 présentant un plot 212 à son extrémité libre et le plot 212 se place dans le logement 208.

Pour assurer le blocage de la languette 206, la carte électronique fond de panier 116 vient en appui contre la face du bras 210 qui est orientée du côté opposé au fond 104, c'est-à-dire ici vers le capot 130. Le bras 210 se trouve ainsi pris en sandwich entre le fond 104 et la carte électronique fond de panier 116.

La carte électronique fond de panier 116 vient en appui contre l'extrémité de la paroi de guidage 126 et est maintenue, du côté du fond 104, par le plot 212 qui s'étend de part et d'autre du bras 210 et, du côté du capot 130, par un clip 214.

Le clip 214 est disposé à l'extrémité de la paroi de guidage 126 orientée du côté opposé à la paroi d'insertion 106 et prend la forme d'une lamelle élastique 216 munie à son extrémité libre d'une dent 218 orientée vers le fond 104.

La mise en place de la carte électronique fond de panier 116 consiste à glisser un bord de ladite carte électronique fond de panier 116 entre l'extrémité de la paroi de guidage 126 et le plot 212, à pivoter la carte électronique fond de panier 116 autour dudit bord ainsi placé, et à amener le bord opposé de la carte électronique fond de panier 116 entre l'extrémité de la paroi de guidage 126 et la dent 218 qui est prévue pour s'écarter lors du passage de ce bord par flexion de la lamelle 216. La carte électronique fond de panier 116 se trouve ainsi prise en sandwich entre la lamelle 216 et le bras 210 et entre la paroi de guidage 126 et la dent 218 d'une part, et, le plot 212, d'autre part.

Pour éviter que la carte électronique fond de panier 116 se libère, le capot 130 vient en appui contre la face de la lamelle 216 qui est orientée vers lui et qui se trouve ainsi prise en sandwich entre la carte électronique fond de panier 116 et le capot 130.

Ainsi, après fermeture du capot 130, la paroi de guidage 126 et la carte électronique fond de panier 116 sont parfaitement maintenues même lors de la mise en place ultérieure des cartes électroniques 120, et ceci sans aucun élément mécanique additionnel.

La Fig. 3 est une coupe le long de la ligne III-III de la Fig. 2.

Pour assurer le maintien en position de la carte électronique fond de panier 116 selon la direction perpendiculaire à la direction de translation 50, la carte électronique fond de panier 116 présente, le long de ses deux bords parallèles au fond 104, au moins une échancrure 302 destiné à loger une des lamelles 216 ou un des bras 210.

L'échancrure 302 du bord de la carte électronique fond de panier 116 qui est orienté vers le fond 104 permet de loger un bras 210 et l'échancrure 302 du bord de la carte électronique fond de panier 116 qui est orienté vers le capot 130 permet de loger une lamelle 216. Une seule de ces conditions est suffisante pour assurer le maintien en position de la carte électronique fond de panier 116.

Dans le mode de réalisation de l'invention, pour chaque lamelle 216 et chaque bras 210 (ici il y a en trois de chaque), la carte électronique fond de panier 116 présente une échancrure 302, c'est-à-dire trois échancrures 302 le long du bord orienté vers le fond 104 et trois échancrures 302 le long du bord orienté vers le capot 130.

Ainsi lors de la mise en place de la carte électronique fond de panier 116, chaque bras 210 et chaque lamelle 216 se logent chacun dans une échancrure 302 et le plot 212, respectivement la dent 218 qui dépasse du bras 210, respectivement de la lamelle 216 vers l'intérieur du châssis 102 déborde de l'échancrure 302 (traits pointillés 212 et 218 sur la Fig. 3) et vient en appui contre la carte électronique fond de panier 116.

La Fig. 4 montre une coupe du boîtier 100 selon le plan IV de la Fig. 1 au voisinage de la paroi d'insertion 106.

Pour assurer un maintien de chaque paroi de guidage 126 par rapport à la paroi d'insertion 106, celle-ci présente un pli 402 qui s'étend parallèlement et au-dessus du fond 104 et le pli 402 présente pour chaque paroi de guidage 126, un embouti 404 vers l'intérieur du châssis 102, c'est-à-dire ici vers le fond 104, présentant une rainure 406 parallèle à la direction de translation 50 et débouchant au niveau de l'extrémité libre du pli 402 et dans laquelle coulisse une extension 408 de ladite paroi de guidage 126 qui présente pour chaque bord de la rainure 406 de l'embouti 404, une rainure 410 dans laquelle loge ladite rainure 406 de l'embouti 404.

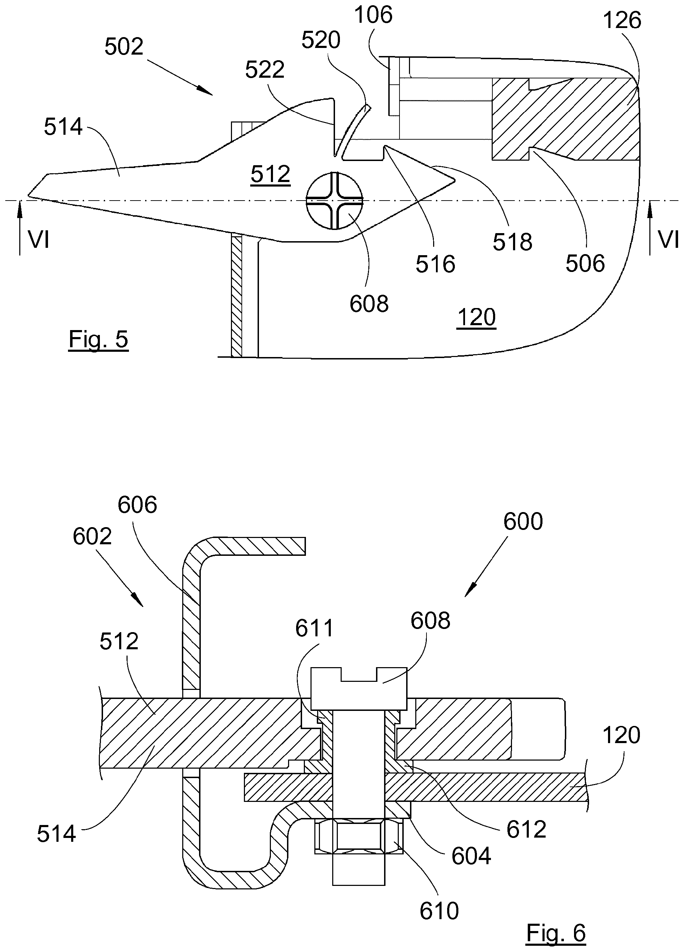

La Fig. 5 est une vue de dessus d'une carte électronique 120 et elle montre un système de maintien et d'extraction 502 qui permet d'améliorer le maintien d'une carte électronique 120 dans le châssis 102 et de faciliter son extraction.

Il y a un ou deux systèmes de maintien et d'extraction 502 par carte électronique 120. Lorsqu'il y a deux systèmes de maintien et d'extraction 502, chacun est disposé à l'un des coins de la carte électronique 120 qui est au voisinage de la paroi d'insertion 106.

La Fig. 6 est une coupe de la Fig. 5 selon la ligne VI-VI et montre une carte électronique équipée 600.

La carte électronique équipée 600 comporte la carte électronique 120, un cache 602 présentant une base 604 et un flanc 606 solidaire de la base 604 et un boulon 608, 610.

La base 604 est parallèle à la carte électronique 120 et se plaque contre une face de la carte électronique 120 et la vis 608 du boulon se visse dans l'écrou 610 du boulon en traversant successivement la carte électronique 120 et la base 604, prenant ainsi en sandwich la carte électronique 120 entre la base 604 et la tête de la vis 608 ou une entretoise comme expliqué ci-après.

L'écrou 610 s'entend également comme pouvant être un filetage réalisé dans la base 604.

Le flanc 606 s'étend perpendiculairement au fond 104 et au plan de la carte électronique 120 et vient en lieu et place de la fenêtre 114 par où est introduite ou extraite la carte électronique 120 pour l'obturer.

Le système de maintien et d'extraction 502 comporte une empreinte femelle 506 réalisée sur le côté de la paroi de guidage 126 et un levier 512 monté mobile en rotation sur la carte électronique 120 autour d'un axe de rotation perpendiculaire au plan de la carte électronique 120 et dont une poignée 514 dépasse de la paroi d'insertion 106 et du flanc 606 vers l'extérieur.

Dans le mode de réalisation de l'invention des Figs. 5 et 6, le levier 512 est traversé et maintenu par la vis 608 et l'axe de rotation est l'axe de la vis 608.

Le levier 512 présente une dent 516 orientée vers l'extérieur et destinée à s'insérer dans l'empreinte femelle 506 sous l'effet d'un moyen formant ressort 520 afin de maintenir la carte électronique équipée 600 en position.

Dans le sens de l'insertion, la partie amont de la dent 516 présente un plan 518 en biais par rapport à la direction de translation 50, qui vient en appui contre l'extrémité de la paroi de guidage 126 afin d'escamoter la dent 516 lors de l'introduction de la carte électronique 120 dans le châssis 102 par rotation du levier 512 (ici dans le sens horaire), jusqu'à ce que la dent 516 atteigne l'empreinte femelle 506 dans laquelle elle se loge sous l'effet du moyen formant ressort 520.

Le moyen formant ressort prend ici la forme d'une languette 520 disposée en aval de la dent 516 en face de l'extrémité de la paroi de guidage 126 et lorsqu'une force est appliquée sur ladite languette 520 selon un sens opposé au sens d'introduction de la carte électronique 120, ladite languette 520 tend à faire pivoter le levier 512 de manière à faire sortir la dent 516 vers l'extérieur (ici dans le sens antihoraire).

Lors de l'introduction de la carte électronique équipée 600 dans le châssis 102 et après que la dent 516 a dépassé l'extrémité libre de la paroi de guidage 126, la languette 520 vient progressivement en appui contre ladite extrémité de la paroi de guidage 126 ce qui tend à faire sortir la dent 516 et donc à la plaquer dans le fond de l'empreinte femelle 506.

Pour extraire la carte électronique équipée 600 du châssis 102, le levier 512 est déplacé en rotation (ici dans le sens antihoraire) de manière à extraire la dent 516 de l'empreinte femelle 506 en contraignant un peu plus la languette 520 qui vient en butée contre une paroi 522 du levier 512 qui s'étend sensiblement perpendiculairement à la direction de translation 50. La languette 520 est alors prise en sandwich entre la paroi 522 formant butée et l'extrémité de la paroi de guidage 126, et la poursuite de la rotation du levier 512 entraîne la mise en appui de la languette 520 et de la paroi 522 formant butée contre la paroi de guidage 126 et l'extraction de la carte électronique équipée 600.

Pour assurer une rotation plus aisée du levier 512, le système de maintien et d'extraction 502 comporte une entretoise 611 cylindrique et coaxiale avec la vis 608. L'entretoise 611 se positionne en appui contre la carte électronique 120, traverse le levier 512 et reçoit la tête de la vis 608. L'entretoise 611 présente également ici une collerette 612 qui s'étend entre la carte électronique 120 et le levier 512 pour écarter le levier 512 de la carte électronique 120.

Le système de maintien et d'extraction 502 peut également être mis en œuvre dans le cadre d'un boîtier différent de celui de l'invention.

## Revendications

1. Boîtier (100) pour au moins une carte électronique (120) présentant un connecteur (122), ledit boîtier (100) comportant :
- un châssis (102) présentant:
- un fond (104) présentant au moins un élément femelle (204) et au moins un logement (208),
- un capot (130), et
- une paroi d'insertion (106) présentant pour la ou chaque carte électronique (120), une fenêtre (114) par où ladite carte électronique (120) peut être introduite ou extraite du châssis (102) selon une direction de translation (50),
- pour la ou chaque carte électronique (120), deux parois de guidage (126), chacune comportant, pour la ou chaque carte électronique (120), une rainure de guidage (128) orientée parallèlement à la direction de translation (50) et destinée à recevoir ladite carte électronique (120),
chaque paroi de guidage (126) comportant:
- au moins un élément mâle (202) prévu pour coopérer avec un élément femelle (204) par insertion dudit élément mâle (202) dans ledit élément femelle (204),
- une languette (206) disposée à l'extrémité de la paroi de guidage (126) orientée du côté opposé à la paroi d'insertion (106), prenant la forme d'un bras (210) présentant, à son extrémité libre, un plot (212) prévu pour s'insérer dans un logement (208),
- un clip (214) disposé à l'extrémité de la paroi de guidage (126) orientée du côté opposé à la paroi d'insertion (106) et prenant la forme d'une lamelle élastique (216) munie à son extrémité libre d'une dent (218) orientée vers le fond (104), et la face de la lamelle (216) qui est orientée vers le capot (130) étant prévue pour venir en appui contre ce-dernier, et
- une carte électronique fond de panier (116) s'étendant parallèlement au plan de la paroi d'insertion (106), présentant un connecteur récepteur (124) prévu pour s'accoupler avec ledit connecteur (122), et prévue pour s'insérer entre la lamelle (216) et le bras (210).

2. Boîtier (100) selon la revendication 1, **caractérisé en ce que** chaque élément femelle (204) prend la forme d'un embouti du fond (104) vers l'intérieur du châssis (102) avec une ouverture orientée du côté opposé à la paroi d'insertion (106), et **en ce que** chaque élément mâle (202) prend la forme d'une barrette issue de la paroi de guidage (126), disposée sous celle-ci et orientée vers la paroi d'insertion (106).

3. Boîtier (100) selon l'une des revendications 1 ou 2, **caractérisé en ce que** la carte électronique fond de panier (116) présente, le long d'au moins l'un de ses deux bords parallèles au fond (104), au moins une échancrure (302) prévue pour y loger une lamelle (216) ou un bras (210).

4. Boîtier (100) selon l'une des revendications 1 à 3, **caractérisé en ce que** la paroi d'insertion (106) présente un pli (402) s'étendant parallèlement au-dessus du fond (104) et présentant, pour chaque paroi de guidage (126), un embouti (404) vers l'intérieur du châssis (102) présentant une rainure (406) parallèle à la direction de translation (50) et débouchant au niveau de l'extrémité libre du pli (402) et dans laquelle coulisse une extension (408) de ladite paroi de guidage (126) qui présente pour chaque bord de la rainure (406) de l'embouti (404), une rainure (410) dans laquelle loge ladite rainure (406) de l'embouti (404).

5. Boîtier (100) selon l'une des revendications 1 à 4, **caractérisé en ce que** la carte électronique (120) est associée à un ou deux systèmes de maintien et d'extraction (502), chacun comportant une empreinte femelle (506) réalisée sur le côté de la paroi de guidage (126), et un levier (512) monté mobile en rotation sur la carte électronique (120) autour d'un axe de rotation perpendiculaire plan de la carte électronique (120) et dont une poignée (514) dépasse vers l'extérieur, le levier (512) présente une dent (516) orientée vers l'extérieur et destinée à s'insérer dans l'empreinte femelle (506) sous l'effet d'un moyen formant ressort (520).

6. Boîtier (100) selon la revendication 5, **caractérisé en ce que** le moyen formant ressort prend la forme d'une languette (520) disposée en aval de la dent (516) en face de l'extrémité de la paroi de guidage (126).

7. Boîtier (100) selon la revendication 6, **caractérisé en ce que** le levier (512) comporte une paroi (522) formant butée contre laquelle ladite languette (520) vient en butée lors de l'extraction de la carte électronique (120).

## Patentansprüche

1. Gehäuse (100) für mindestens eine elektronische Platine (120) aufweisend einen Verbinder (122), das Gehäuse (100) umfassend:
- einen Rahmen (102) aufweisend:
- einen Boden (104) aufweisend mindestens ein aufnehmendes Element (204) und mindestens eine Aufnahme (208),
- eine Abdeckung (130), und
- eine Einschubwand (106), die für die oder jede elektronische Platine (120) ein Fenster (114) aufweist, durch welches die elektronische Platine (120) in einer Translationsrichtung (50) in den Rahmen (102) eingeführt oder aus diesem entnommen werden kann,
- für die oder jede elektronische Platine (120) zwei Führungswände (126), die jeweils für die oder jede elektronische Platine (120) eine Führungsnut (128) aufweisen, die parallel zur Translationsrichtung (50) ausgerichtet und zum Aufnehmen der elektronischen Platine (120) bestimmt ist,
wobei jede Führungswand (126) Folgendes umfasst:
- mindestens ein vorstehendes Element (202), das zum Zusammenwirken mit einem aufnehmenden Element (204) durch Einsetzen des vorstehenden Elements (202) in das aufnehmende Element (204) vorgesehen ist,
- eine Zunge (206), die an dem Ende der Führungswand (126) angeordnet ist, das von der Einschubwand (106) abgewandt ist, in Form eines Arms (210), der an seinem freien Ende einen Zapfen (212) aufweist, der dafür vorgesehen ist, in eine Aufnahme (208) eingeführt zu werden,
- ein Klemmelement (214), das an dem Ende der Führungswand (126) angeordnet ist, das von der Einschubwand (106) abgewandt ist und die Form einer elastischen Lamelle (216) aufweist, die an ihrem freien Ende mit einem Zahn (218) versehen ist, der dem Boden (104) zugewandt ist, und wobei die Seite der Lamelle (216), die der Abdeckung (130) zugewandt ist, zum Aufliegen auf dieser vorgesehen ist, und
- eine elektronische Korbboden-Platine (116), die sich parallel zur Ebene der Einschubwand (106) erstreckt, die einen Aufnahmeverbinder (124) aufweist, der dafür vorgesehen ist, mit dem Verbinder (122) zusammenzupassen, und dafür vorgesehen ist, zwischen die Lamelle (216) und den Arm (210) eingefügt zu werden.

2. Gehäuse (100) nach Anspruch 1, **dadurch gekennzeichnet, dass** jedes aufnehmende Element (204) die Form einer Einbuchtung vom Boden (104) hin zum Inneren des Rahmens (102) mit einer Öffnung aufweist, die der Einschubwand (106) abgewandt ist, und dadurch, dass jedes vorstehende Element (202) die Form eines Stollens von der Führungswand (126) aufweist, der unterhalb davon angeordnet und der Einschubwand (106) zugewandt ist.

3. Gehäuse (100) nach einem der Ansprüche 1 oder 2, **dadurch gekennzeichnet, dass** die elektronische Korbboden-Platine (116) entlang mindestens einer ihrer zwei Ränder, die parallel zum Boden (104) verlaufen, mindestens eine Aussparung (302) aufweist, die dafür vorgesehen ist, darin eine Lamelle (216) oder einen Arm (210) aufzunehmen.

4. Gehäuse (100) nach einem der Ansprüche 1 bis 3, **dadurch gekennzeichnet, dass** die Einschubwand (106) eine Falte (402) aufweist, die sich parallel über dem Boden (104) erstreckt und für jede Führungswand (126) eine Einbuchtung (404) hin zum Inneren des Rahmens (102) aufweist, die eine Nut (406) aufweist, die parallel zur Translationsrichtung (50) verläuft und am freien Ende der Falte (402) mündet, und in der eine Verlängerung (408) der Führungswand (126) gleitet, die für jeden Rand der Nut (406) der Einbuchtung (404) eine Nut (410) aufweist, in der die Nut (406) der Einbuchtung (404) aufgenommen ist.

5. Gehäuse (100) nach einem der Ansprüche 1 bis 4, **dadurch gekennzeichnet, dass** die elektronische Platine (120) mit einem oder zwei Halte- oder Entnahmesystemen (502) in Verbindung steht, jeweils umfassend eine aufnehmende Einkerbung (506), die auf der Seite der Führungswand (126) ausgebildet ist, und einen Hebel (512), der auf der elektronischen Platine (120) um eine Drehachse herum drehbeweglich gelagert ist, die senkrecht zu der Ebene der elektronischen Platine (120) verläuft, und von dem ein Griff (514) nach außen hin absteht, der Hebel (512) einen Zahn (516) aufweist, der nach außen gewandt ist und dazu bestimmt ist, unter der Wirkung eines Federmittels (520) in die aufnehmende Einkerbung (506) eingefügt zu werden.

6. Gehäuse (100) nach Anspruch 5, **dadurch gekennzeichnet, dass** das Federmittel die Form einer Zunge (520) aufweist, die stromabwärts des Zahns (516) gegenüber dem Ende der Führungswand (126) angeordnet ist.

7. Gehäuse (100) nach Anspruch 6, **dadurch gekennzeichnet, dass** der Hebel (512) eine Anlagewand (522) umfasst, gegen welche die Zunge (520) bei der der Entnahme der elektronischen Platine (120) zur Anlage kommt.

## Claims

1. Housing (100) for at least one electronic card (120) having a connector (122), said housing (100) comprising:
- a chassis (102) having:
- a base (104) having at least one female element (204) and at least one pocket (208),
- a cover (130), and
- an insertion wall (106) having, for the or each electronic card (120), a window (114) through which said electronic card (120) can be introduced into or extracted from the chassis (102) according to a translation direction (50),
- for the or each electronic card (120), two guide walls (126), each comprising, for the or each electronic card (120), a guide groove (128) oriented parallel to the translation direction (50) and intended to receive said electronic card (120),
each guide wall (126) comprising:
- at least one male element (202) designed to cooperate with a female element (204) by insertion of said male element (202) in said female element (204),
- a tongue (206) disposed at the end of the guide wall (126) oriented on the side opposite to the insertion wall (106), taking the form of an arm (210) having, at its free end, a stud (212) designed to be inserted in a pocket (208),
- a clip (214) disposed at the end of the guide wall (126) oriented on the side opposite to the insertion wall (106) and taking the form of an elastic blade (216) provided at its free end with a tooth (218) oriented towards the base (104), and the face of the blade (216) that is oriented towards the cover (130) being designed to come into abutment against the latter, and
- a backplane electronic card (116) extending parallel to the plane of the insertion wall (106), having a receiving connector (124) designed to be coupled to said connector (122), and designed to be inserted between the blade (216) and the arm (210).

2. Housing (100) according to claim 1, **characterised in that** each female element (204) takes the form of a deep drawing of the base (104) towards the inside of the chassis (102) with an opening oriented on the side opposite to the insertion wall (106), and **in that** each male element (202) takes the form of a bar issuing from the guide wall (126), disposed under the latter and oriented towards the insertion wall (106).

3. Housing (100) according to one of claims 1 or 2, **characterised in that** the backplane electronic card (116) has, along at least one of its two edges parallel to the base (104), at least one scallop (302) designed for housing a blade (216) or an arm (210) therein.

4. Housing (100) according to one of claims 1 to 3, **characterised in that** the insertion wall (106) has a fold (402) extending parallel above the base (104) and having, for each guide wall (126), a deep drawing (404) towards the inside of the chassis (102) having a groove (406) parallel to the translation direction (50) and emerging at the free end of the fold (402) and in which there slides an extension (408) of said guide wall (126) that has, for each edge of the groove (406) of the deep drawing (404), a groove (410) in which said groove (406) of the deep drawing (404) is housed.

5. Housing (100) according to one of claims 1 to 4, **characterised in that** the electronic card (120) is associated with one or two holding and extraction systems (502), each comprising a female hollow (506) produced on the side of the guide wall (126), and a lever (512) mounted so as to be able to rotate on the electronic card (120) about a rotation axis perpendicular to the plane of the electronic card (120), and a handle (514) of which projects outwards, the lever (512) has a tooth (516) oriented outwards and intended to be inserted in the female hollow (506) under the effect of a means forming a spring (520).

6. Housing (100) according to claim 5, **characterised in that** the means forming a spring takes the form of a tongue (520) disposed downstream of the tooth (516) facing the end of the guide wall (126).

7. Housing (100) according to claim 6, **characterised in that** the lever (512) comprises a wall (522) forming a stop, against which said tongue (520) comes into abutment when the electronic card (120) is extracted.
